# EUROPEAN PATENT SPECIFICATION

(11) **EP 4 161 236 B1**
(45) Date of publication and mention of the grant of the patent: **09.04.2025**
(21) Application number: 22196082.6
(22) Date of filing: 16.09.2022
(51) Int. Cl.: H10K 59/80, H10K 59/124, H10K 59/40

(54) **DISPLAY PANEL AND DISPLAY APPARATUS COMPRISING THE SAME**
ANZEIGETAFEL UND ANZEIGEVORRICHTUNG DAMIT
PANNEAU D'AFFICHAGE ET APPAREIL D'AFFICHAGE LE COMPRENANT

(30) Priority: 30.09.2021 KR 20210130414
(43) Date of publication of application: 05.04.2023
(73) Proprietor: LG Display Co., Ltd., SEOUL, 07336 (KR)
(72) Inventor: JIN, Jungdoo, 10845 Paju-si, Gyeonggi-do (KR); YU, Seonha, 10845 Paju-si, Gyeonggi-do (KR)
(74) Representative: Viering, Jentschura & Partner mbB Patent- und Rechtsanwälte

(56) References cited:
- EP-A1- 3 886 196
- CN-A- 110 767 736
- US-A1- 2020 273 927
- US-A1- 2021 183 983
- US-A1- 2021 241 671

## Description

### CROSS-REFERENCE TO RELATED APPLICATION

This application claims the benefit of and priority to Korean Patent Application No. 10-2021-0130414, filed on September 30, 2021.

### TECHNICAL FIELD

The present disclosure relates to an apparatus, including, without limitation, a display panel and a display apparatus comprising the same.

### BACKGROUND

With advancement of information technology, various display devices such as laptops, tablet personal computers (PCs), smartphones, and smart watches have been widely utilized. Such a display device may have a data generation function of various methods in addition to an image display function. An electronic device may include a display panel for a display function and an optical sensor for data generation. An optical sensor may include, for example, a charge coupled device (CCD), a camera, and an infrared sensor.

The display panel may include a signal line or electrode pattern of a light shielding material. Accordingly, in order to prevent light directed to the optical sensor from being reflected or absorbed by the display panel, the optical sensor may be disposed on the display panel. In this case, a bezel width of the display panel may be increased due to the region where the optical sensor is disposed, or an area overlapping the optical sensor within the display area of the display panel may be covered by the optical sensor, thereby limiting an image display function. Such display panels are described in US 2020/273927 A1, EP 3 886 196 A1, US 2021/183983 A1 and US 2021/241671 A1. That is, since an image may be prevented from being displayed within a portion of the display area of the display panel, it may be difficult to implement a full screen display.

The description provided in the background section should not be assumed to be prior art merely because it is mentioned in or associated with the background section. The background section may include information that describes one or more aspects of the subject technology.

### SUMMARY

In one or more implementations, an object of embodiments of the present disclosure is to provide a display panel for minimizing a cathode lifting phenomenon that may occur during a cathode patterning process related to the formation of a light transmittance portion, and a display apparatus having the same.

However, the objects of the present disclosure are not limited to those mentioned above, and additional objects and features of the present disclosure will be clearly understood by those skilled in the art from the following description of the present disclosure. According to an aspect of the present invention, a display panel according to claim 1 is provided. Further embodiments are described in the dependent claims.

In an aspect of the present invention, a display panel includes a planarization layer on which pixels are disposed, a first area in which a plurality of pixels are disposed, and a second area comprising at least two pixel groups. Each of the at least two pixel groups includes at least one pixel, a light transmittance portion disposed between the at least two pixel groups to transmit light, and a hole formed to correspond to a boundary of the light transmittance portion along the boundary of the light transmittance portion. The hole is disposed on the same plane as at least a portion of the planarization layer and has a predetermined depth being less than a thickness of the planarization layer. A cathode related to the at least one pixel is disposed in at least a part of the hole.

In an aspect of the present invention, a display apparatus includes a display panel comprising a planarization layer on which pixels are disposed, a first area in which a plurality of pixels are disposed, and a second area including at least two pixel groups. Each of the at least two pixel groups includes at least one pixel, a light transmittance portion disposed between the at least two pixel groups to transmit light, and a hole formed to correspond to a boundary of the light transmittance portion along the boundary of the light transmittance portion. The hole is disposed on the same plane as at least a portion of the planarization layer and has a predetermined depth being less than a thickness of the planarization layer. A cathode related to the at least one pixel may be disposed in at least a part of the hole.

Additional aspects and features are set forth in part in the description that follows and in part will become apparent from the description or may be learned by practice of the inventive concepts provided herein. Other features and aspects of the inventive concepts may be realized and attained by the structures particularly pointed out in the written description, or derivable therefrom, and the claims hereof as well as the appended drawings. The specific details of other example embodiments are included in the detailed description and drawings.

According to one or more examples of a display apparatus of the present disclosure, it is possible to minimize a cathode lifting phenomenon that may occur during a cathode patterning process related to the formation of a light transmittance portion by disposing the cathode in a hole formed to correspond to a boundary of the light transmittance portion.

However, the effects obtainable from the embodiments of the present disclosure are not limited to the above-mentioned effects, and other effects not mentioned may be clearly understood by those of ordinary skill in the art to which this disclosure belongs from the description herein.

In addition, other methods, features, configurations, and advantages will be apparent to one with skill in the art upon examination of the following figures and detailed description. It is intended that all such additional methods, features, configurations, and advantages be included within this description, be within the scope of the present disclosure, and be protected by the following claims. Nothing in this section should be taken as a limitation on those claims. Further aspects and advantages are discussed below.

It is to be understood that both the foregoing general description and the following detailed description of the present disclosure are exemplary and explanatory and are intended to provide further explanation of the disclosure as claimed.

### BRIEF DESCRIPTION OF THE DRAWINGS

The accompanying drawings, which are included to provide a further understanding of the disclosure and are incorporated in and constitute a part of this application, illustrate aspects and embodiments of the disclosure and together with the description serve to explain the principle of the disclosure.
FIG. 1 illustrates one surface of a display apparatus according to an example embodiment of the present disclosure.
FIG. 2 illustrates a pixel arrangement in a first area of a display apparatus according to an example embodiment of the present disclosure.
FIG. 3 illustrates a pixel arrangement in a second area of a display apparatus according to an example embodiment of the present disclosure.
FIG. 4 is a cross-sectional view of a portion of a display apparatus according to an example embodiment of the claimed invention.
FIG. 5 is a diagram for explaining a hole of a display apparatus according to an example embodiment of the claimed invention.
FIGS. 6 and 7 are diagrams for explaining examples and arrangements of holes of a display apparatus according to example embodiments of the claimed invention.
FIGS. 8A, 8B, and 8C are diagrams for explaining examples of a hole of a display apparatus according to example embodiments of the claimed invention.
FIGS. 9A and 9B are diagrams for explaining examples of a cathode disposed in a hole of a display apparatus according to example embodiments of the claimed invention.

Throughout the drawings and the detailed description, unless otherwise described, the same drawing reference numerals should be understood to refer to the same elements, features, and structures. The relative size and depiction of these elements may be exaggerated for clarity, illustration, and convenience.

### DETAILED DESCRIPTION

Reference will now be made in detail to embodiments of the present disclosure, examples of which may be illustrated in the accompanying drawings.

In the following description, the structures, embodiments, implementations, methods and operations described herein are not limited to the specific example or examples set forth herein and may be changed as is known in the art, unless otherwise specified. Like reference numerals designate like elements throughout, unless otherwise specified. Names of the respective elements used in the following explanations are selected only for convenience of writing the specification and may thus be different from those used in actual products.

Advantages and features of the present disclosure and methods for achieving them will become apparent with reference to the embodiments described below in detail in conjunction with the accompanying drawings. The present disclosure may, however, be embodied in different forms and should not be construed as limited to the example embodiments set forth herein. Rather, these example embodiments are provided so that this disclosure may be sufficiently thorough and complete to assist those skilled in the art to fully understand the scope of the present disclosure. Further, the protected scope of the present disclosure is defined by the claims. In the following description, where the detailed description of the relevant known function or configuration may unnecessarily obscure aspects of the present disclosure, a detailed description of such known function or configuration may be omitted.

In one or more aspects, the terms used in the embodiments are selected as currently widely used general terms as possible while considering the functions in the present disclosure, which may vary depending on the intention of a person skilled in the art, the precedent, the emergence of new technology, or other considerations. In addition, certain terms may be arbitrarily selected by the inventors, and in these cases, the meaning thereof are described in the corresponding description. Therefore, the terms used in the present disclosure should be defined based on the meaning of the terms and the overall contents of the present disclosure, rather than the simple name of the terms.

In the present disclosure, when a part "includes" an element, it means that other elements may be further included, rather than excluding other elements, unless otherwise stated.

The expression of "at least one of" A, B, and C may include a configuration of A alone, B alone, C alone, A and B, A and C, B and C, or all of A, B, and C.

The expression of a first element, a second elements "and/or" a third element should be understood as one of the first, second and third elements or as any or all combinations of the first, second and third elements. By way of example, A, B and/or C can refer to only A, only B, only C, any or some combination of A, B, and C, or all of A, B, and C.

The shapes, sizes, areas, ratios, angles, numbers, and the like disclosed in the drawings for explaining the embodiments in the present disclosure are merely examples, and thus, the present disclosure is not limited to the illustrated details.

Where the term "comprise," "have," "include," "contain," "constitute," "make up of," "formed of," or the like is used, one or more other elements may be added unless the term, such as "only" is used. The terms of a singular form may include plural forms unless explicitly stated otherwise. In addition, in construing an element, the element is to be construed as including an error or tolerance range even where no explicit description of such an error or tolerance range is provided.

Where positional relationships are described, for example, where the positional relationship between two parts is described using "on," "over," "under," "above," "below," "beneath," "near," "close to," "adjacent to," "beside," "next to," or the like, one or more other parts may be located between the two parts unless a more limiting term, such as "immediate(ly)," "direct(ly)," or "close(ly)" is used. For example, when a structure is described as being positioned "on," "over," "under," "above," "below," "beneath," "near," "close to," "adjacent to," "beside," or "next to" another structure, this description should be construed as including a case in which the structures contact each other as well as a case in which one or more additional structures are disposed or interposed therebetween. Furthermore, the terms "left," "right," "top," "bottom, "downward," "upward," "upper," "lower," and the like refer to an arbitrary frame of reference.

In describing a temporal relationship, when the temporal order is described as, for example, "after," "subsequent," "next," or "before," a case which is not continuous may be included unless a more limiting term, such as "just," "immediate(ly)," or "direct(ly)" is used.

For the expression that an element or layer is "connected," "coupled," or "adhered" to another element or layer, the element or layer can not only be directly connected, coupled, or adhered to another element or layer, but also be indirectly connected, coupled, or adhered to another element or layer with one or more intervening elements or layers disposed or interposed between the elements or layers, unless otherwise specified.

For the expression that an element or layer "contacts," "overlaps," or the like with another element or layer, the element or layer can not only directly contact, overlap, or the like with another element or layer, but also indirectly contact, overlap, or the like with another element or layer with one or more intervening elements or layers disposed or interposed between the elements or layers, unless otherwise specified.

When the terms, such as "first," "second," or the like, are used herein to describe various elements or components, it should be understood that these elements or components are not limited thereto. These terms are merely used herein for distinguishing an element from other elements. For example, a first element could be a second element, and, similarly, a second element could be a first element, without departing from the scope of the present disclosure.

The area, length, or thickness of each component described in the present disclosure is illustrated for convenience of description, and the present invention is not necessarily limited to the area, length, and thickness of the illustrated component.

The features of each of the embodiments of the present disclosure may be partially or wholly combined or coupled with each other and may be technically linked or operated together. In addition, each of the embodiments may be implemented independently of each other or may be implemented together in a related relationship.

In addition, the terms to be described later are terms defined in consideration of functions in the implementation of the present disclosure, which may vary depending on the intention or custom of a user or operator. Therefore, the terms should be interpreted based on the content throughout this present disclosure.

Expressions such as "first," "second," and "third" are terms used to classify configurations according to example embodiments, and embodiments are not limited to these terms. Therefore, it should be noted that even the same terms may refer to different components according to example embodiments.

The following example embodiments may be described with respect to an organic light emitting diode display device. However, embodiments of the present disclosure are not limited to an organic light emitting display device and may be applied to an inorganic light emitting display device including an inorganic light emitting material. For example, embodiments of the present disclosure may be applied to a quantum dot display device. In addition, embodiments of the present disclosure may be applied to various devices capable of performing an inspection using an inspection device in addition to a display device.

Various example embodiments of the present disclosure are described below with reference to the drawings. In addition, for convenience of description, a scale in which each of elements is illustrated in the accompanying drawings may differ from an actual scale. Thus, the illustrated elements are not limited to the specific scale in which they are illustrated in the drawings.

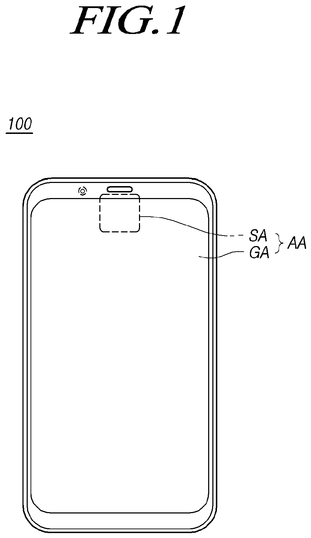

FIG. 1 illustrates one surface of a display apparatus according to an example embodiment of the present disclosure. For example, FIG. 1 may be a diagram illustrating a front surface of a display apparatus.

FIG. 1 illustrates an example in which a display apparatus 100 is implemented in the form of a smart phone; however, embodiments are not limited thereto. A display apparatus 100 may be implemented as one or more of various electronic devices (e.g., smart watch, tablet PC, or the like).

Referring to FIG. 1, the display apparatus 100 may include a display panel including an active area (which may be referred as a display area) AA for an image display function and an optical sensor for an image capturing function (or a sensing function).

The display panel may be configured to display various contents on the display apparatus 100 and may include, for example, a luminous element (e.g., an organic light emitting device). The display panel may be disposed on a front surface of the display apparatus 100. There may be omitted the descriptions of general contents that are obvious to those of ordinary skill in the art in relation to the display panel in the present disclosure.

The optical sensor may correspond to an optical element for detecting light passing through the display panel. For example, the optical sensor is an optical element for generating an electrical signal corresponding to the amount of light reflected by a target object, and may include, for example, at least one of a camera, a charge coupled device (CCD), and an infrared sensor.

In an example embodiment, a part of the display area AA of the display panel may overlap the optical sensor disposed under the display panel. In this case, a part of the display area AA may correspond to a sensing area SA (or a light sensing area) overlapping the optical sensor, and the other part of the display area AA may correspond to a general area GA differentiated from the sensing area.

In an example embodiment, the sensing area SA may provide an image (or image) display function and a light transmission function. For example, while an image is displayed in the sensing area SA, light directed to the optical sensor may be transmitted. In this way, an area through which light directed to the optical sensor is transmitted within the sensing area SA may be referred to as a light transmittance portion, and an area other than the light transmittance portion within the sensing area SA may be referred to as a pixel area. However, the present disclosure is not limited thereto.

In an example embodiment, at least one pixel may be disposed in the sensing area SA and the general area GA. A density at which pixels are disposed in the sensing area SA may be lower than a density at which pixels are disposed in the general area GA. That is, a pixel density of the sensing area SA may be lower than a pixel density of the general area GA. The resolution of the sensing area SA may be lower than that of the general area GA.

FIG. 1 illustrates an example in which the sensing area SA is disposed in an upper center of the display apparatus 100, but the present disclosure is not limited thereto, and may be disposed in other parts of the display apparatus 100. For example, the sensing area SA may be disposed at an upper left, upper right, or center of the display apparatus 100.

Hereinafter, the general area GA may be referred to as a first area and the sensing area SA may be referred to as a second area; however, embodiments of the present disclosure are not limited thereto.

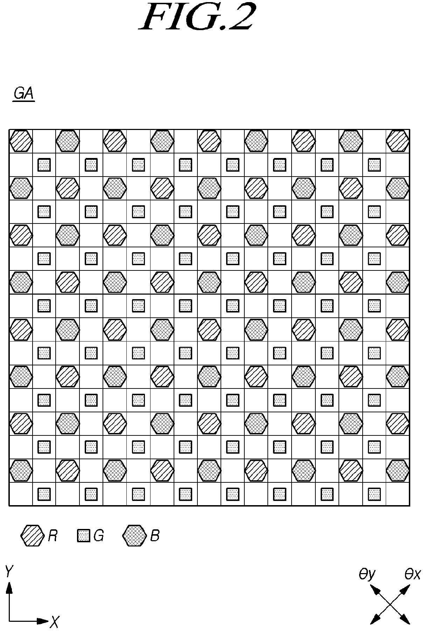

FIG. 2 illustrates a pixel arrangement in a first area of a display apparatus according to an example embodiment of the present disclosure.

Referring to FIG. 2, the first area (or general area) GA includes pixels arranged at high pixels per inch (PPI). Each of the pixels may include at least one sub-pixel selected from a red (R) sub-pixel, a green (G) sub-pixel, and a blue (B) sub-pixel. In some cases, at least some of the pixels may further include a white (W) sub-pixel (not shown).

In an example embodiment, the luminous efficiency of a luminous element may be determined according to the color of the sub-pixel. In consideration of this, a size of the sub-pixels may be determined according to the color. For example, among R, G, and B sub-pixels, the B sub-pixel may be the largest and the G sub-pixel may be the smallest.

The pixels may be repeatedly arranged in a first direction (X-axis), a second direction (Y-axis) orthogonal to the first direction, and an inclination angle direction (Θx and Θy axes) between the first and second directions. The Θx and Θy may indicate the direction of the inclination axis in which the X and Y axes are rotated by 45°, respectively.

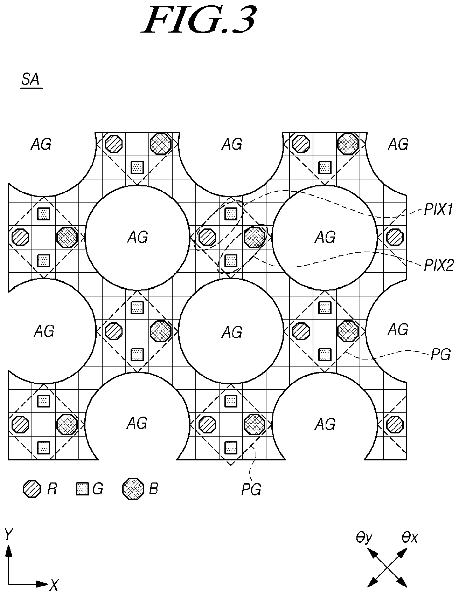

FIG. 3 illustrates a pixel arrangement in a second area of a display apparatus according to an example embodiment of the present disclosure.

Referring to FIG. 3, the second area (or sensing area) SA includes at least two pixel groups PG, wherein each pixel group includes at least one pixel and a light transmittance portion AG. As illustrated, the second area SA may include a plurality of pixel groups and a plurality of light transmittance portions. Each of the pixel groups PG may be disposed to be spaced apart from each other by a predetermined distance. The light transmittance portion AG may be disposed in a space between the pixel groups PG.

In an example embodiment, light from the outside of the display apparatus may be received through the light transmittance portion AG by a lens disposed to correspond to the light transmittance portion AG. The light transmittance portion AG may include a transparent medium having high transmittance. The light transmittance portion AG may include a non-metal material. For example, the light transmittance portion AG may be made of a transparent insulating material without including metal lines or pixels. According to an example embodiment, the light transmittance portions AG may be defined as areas in which all metal layers are removed from the screen, but the present disclosure is not limited thereto.

In an example embodiment, the transmittance of the display area may be determined according to at least one of the number and size of the light transmittance portions AG. For example, the transmittance of the display area may have a higher value as the size of the light transmittance portions AG increases or the number of the light transmittance portions AG increases. Comparing FIG. 2 and FIG. 3, since the light transmittance portion AG is disposed in the second area SA, the transmittance of the second area SA may be higher than that of the first area GA. Accordingly, the PPI of the second area SA may be lower than the PPI of the first area GA.

In an example embodiment, the pixel group PG may include at least one sub-pixel corresponding to one of R, G, and B. For example, as illustrated in FIG. 3, a pixel group PG may include one R sub-pixel, two G sub-pixels and one B sub-pixel.

In an example embodiment, the pixel group PG disposed in the second area SA may include two pixels PIX1 and PIX2 each including at least one sub-pixel. For example, the pixel group PG may include a first pixel PIX1 and a second pixel PIX2. The first pixel PIX1 may include an R sub-pixel and a G sub-pixel, and the second pixel PIX2 may include a B sub-pixel and a G sub-pixel.

In an example embodiment, the insufficient color representation in each of the first and second pixels PIX1 and PIX2 may be compensated by an average value of corresponding color data between neighboring pixels based on the sub-pixel rendering algorithm. For example, white may be expressed by combining the R, G, and B sub-pixels of the first and second pixels PIX1 and PIX2.

In an example embodiment, the shape of the light transmittance portion AG and the arrangement shape of the pixel group PG may be implemented in various forms. For example, the light transmittance portion AG may be formed in a circular shape or an elliptical shape. In this case, a captured image in which a flare phenomenon is minimized may be obtained, and transmittance of the second area SA may be improved. The pixel group PG may have a circular shape, an oval or elliptical shape, a rhombus shape, or a square shape.

In an example embodiment, the light transmittance portion AG may not include a metal. In this regard, a metal used as a cathode electrode (or a first electrode) (which may be referred to as a cathode) in the manufacturing step of the display panel may be removed from the light transmittance portion AG. For example, first, a metal used as the cathode may be uniformly deposited on the second area. Thereafter, the metal in the area corresponding to the light transmittance portion AG may be removed from the second area using, for example, a laser process.

In an example embodiment, each of the pixel groups PG may include a circuit layer in which a pixel circuit of each sub-pixel is disposed and a light emitting device. At least a portion of the circuit layer and the light emitting device layer may overlap or be spatially separated.

In an example embodiment, the circuit layers of the pixel group PG may be arranged to correspond to the arrangement shape of the pixel group PG. For example, if the pixel group PG is arranged in a shape of rhombus or a square, the circuit layer may also be arranged in a shape of rhombus or a square.

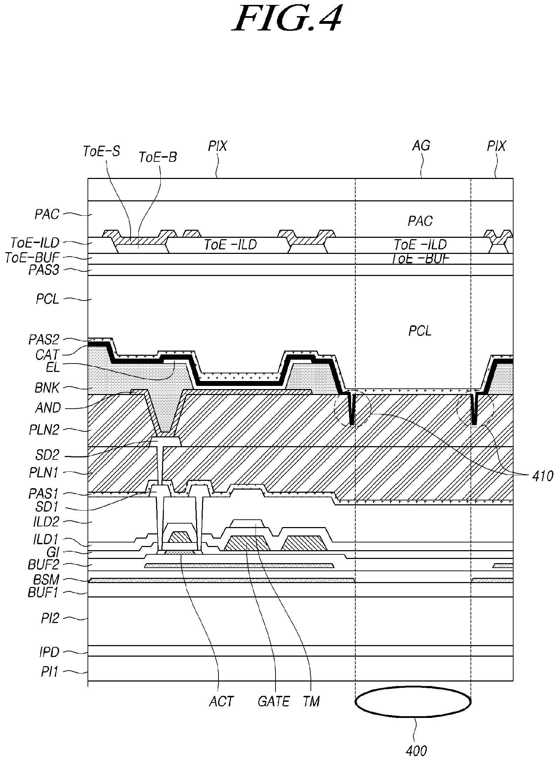

FIG. 4 is a cross-sectional view of a portion of a display apparatus according to an example embodiment of the claimed invention. Specifically, FIG. 4 is an example of a diagram for explaining a cross-section of a light transmittance portion and a peripheral area of a display apparatus.

In FIG. 4, a thin film transistor (TFT) may represent a driving transistor DT of a pixel circuit. Referring to FIG. 4, a circuit layer, a light emitting device layer, and the like may be stacked on substrates PI1 and PI2 in a pixel area PIX. The substrate PI1 and PI2 may include a first PI substrate PI1 and a second PI substrate PI2. An inorganic layer IPD may be positioned between the first PI substrate PI1 and the second PI substrate PI2. The inorganic layer IPD can block water penetration.

A first buffer layer BUF1 may be formed on the second substrate PI2. A first metal layer BSM may be formed on the first buffer layer BUF1, and a second buffer layer BUF2 may be formed on the first buffer layer BUF1 to surround the first metal layer BSM. Each of the first and second buffer layers BUF1 and BUF2 may be formed of an inorganic insulating material and may include one or more insulating layers.

In some cases, the first metal layer BSM may be formed under the first buffer layer BUF1. In this case, the first and second buffer layers BUF1 and BUF2 may be formed on the first metal layer BSM.

The first metal layer BSM may be patterned in a photolithography process. The first metal layer BSM may include a light shield pattern. The light shield pattern may block external light so that light is not irradiated to an active layer of the TFT, thereby preventing a photo current of the TFT formed in the pixel area. If the light shield pattern is formed of a metal having a lower absorption coefficient of a laser wavelength used in a laser ablation process compared to a metal layer (e.g., a cathode) to be removed from a sensing area SA, the light shield pattern may serve as a shielding layer for blocking a laser beam LB in the laser ablation process.

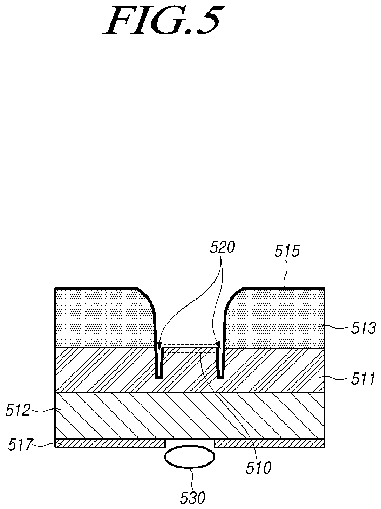

In an example embodiment, the first metal layer BSM may be disposed to cover the lower region of a hole 410 as shown, and an example related thereto is described later with reference FIG. 5.

An active layer ACT may be formed of a semiconductor material on the second buffer layer BUF2 and patterned by a photolithography process. The active layer ACT may include an active pattern of each of the TFTs of the pixel circuit and the TFTs of the gate driver. A portion of the active layer ACT may be metallized by ion doping. The metallized portion may be used as a jumper pattern connecting metal layers at some nodes of the pixel circuit to connect components of the pixel circuit.

A gate insulating layer GI may be formed on the second buffer layer BUF2 to cover the active layer ACT. The gate insulating layer GI may be formed of an inorganic insulating material.

A second metal layer GATE may be formed on the gate insulating layer GI. The second metal layer GATE may be patterned by a photolithography process. The second metal layer GATE may be used as a gate line, a gate electrode, a lower electrode of a storage capacitor, and a jumper pattern connecting patterns of the first metal layer BSM and a third metal layer TM.

A first interlayer insulating layer ILD1 may be formed on the gate insulating layer GI to cover the second metal layer GATE. The third metal layer TM may be formed on the first interlayer insulating layer ILD1, and a second interlayer insulating layer ILD2 may cover the third metal layer TM. The third metal layer TM may be patterned by a photolithography process. The third metal layer TM may include metal patterns such as the upper electrode of the storage capacitor. The first and second interlayer insulating layers ILD1 and ILD2 may include an inorganic insulating material.

A fourth metal layer SD1 may be formed on the second interlayer insulating layer ILD2, and an inorganic insulating layer PAS1 and a first planarization layer PLN1 are stacked thereon. A fifth metal layer SD2 may be formed on the first planarization layer PLN1. The first and second planarization layers PLN1 and PLN2 may be formed of an organic insulating material for flattening surfaces.

The fourth metal layer SD1 may be connected to the first and second electrodes of the TFT connected to the active pattern of the TFT through a contact hole penetrating the second interlayer insulating layer ILD2. The data lines and power lines may be implemented with the fourth metal layer SD1 or a fifth metal layer SD2.

An anode electrode (or a second electrode) (which may be referred to as an anode) AND may be formed on the second planarization layer PLN2. The anode AND may be a first electrode layer of a luminous element, which may be, for example, an organic light emitting diode (OLED). The anode AND may be connected to an electrode of the driving TFT through a contact hole passing through the second planarization layer PLN2. The anode AND may be formed of a transparent or translucent electrode material.

A pixel defining layer (or bank) BNK may cover the anode AND of the luminous element (e.g., an OLED). The pixel defining layer BNK may be formed in a pattern defining a light emitting area (or an opening area) through which light passes from each of the pixels to the outside. A spacer SPC may be formed on the pixel defining layer BNK.

In some cases, the pixel defining layer BNK and the spacer SPC may be integrated with the same organic insulating material. The spacer SPC may secure a gap between a fine metal mask (FMM) and the anode AND so that the FMM is not in contact with the anode AND during the deposition process of an emission layer (or organic compound) EL.

The emission layer EL may be formed in each of the light emitting area of the pixels defined by the pixel defining layer BNK. A cathode CAT, which may be a second electrode layer of the luminous element (e.g., an OLED), may be formed on the entire surface of the display apparatus 100 to cover the pixel defining layer BNK, the spacer SPC, and the emission layer EL. The cathode CAT may be connected to a low supply voltage (VSS) line formed of any one of the metal layers thereunder.

Although not shown, a capping layer CPL may be disposed on the cathode CAT. The capping layer CPL may cover the cathode CAT. The capping layer CPL may be formed of an inorganic insulating material to block penetration of air and out gassing of an organic insulating material applied on the capping layer CPL to protect the cathode CAT. An encapsulation layer may be disposed on the capping layer CPL. According to an example embodiment, the capping layer CPL may be included in the encapsulation layer.

The encapsulation layer may include inorganic insulating layers PAS2 and PAS3, and a foreign material compensation layer PCL therebetween. For example, a lower inorganic insulating layer PAS2 may cover the capping layer CPL, and the foreign material compensation layer PCL may be formed on the lower inorganic insulating layer PAS2. The foreign material compensation layer PCL may include an organic insulating material. An upper inorganic insulating layer PAS3 may be formed on the foreign material compensation layer PCL.

A touch configuration may be disposed on the upper inorganic insulating layer. For example, a touch buffer ToE-BUF and a touch insulating layer ToE-ILD may be disposed on the upper inorganic insulating layer. A touch bridge ToE-B and a touch sensor ToE-S may be disposed in a hole formed in at least a portion of the touch insulating layer. At least a portion of the touch sensor ToE-S may be disposed on the touch bridge ToE-B, and at least another portion of the touch sensor ToE-S may be disposed on the touch insulating layer ToE-ILD. A photoacrylic PAC may be disposed on the touch insulating layer ToE-ILD and the touch sensor ToE-S. The photoacrylic PAC may be an organic insulating layer.

Still referring to FIG. 4, the cathode CAT is disposed in the pixel area PIX but may be omitted in the light transmittance portion AG between the pixel areas PIX. Accordingly, an opening in which the cathode CAT is omitted may be formed. That is, the cathode CAT may be formed up to a boundary of the opening. In this case, the opening may be formed as wide as an area corresponding to the light transmittance portion AG. The opening may be formed by forming the cathode CAT on the pixel defining layer BNK and then etching the cathode CAT and the pixel defining layer BNK at once. However, the present disclosure is not limited thereto, and the opening may be formed in various ways.

A sensor (or an optical sensor) 400 may be disposed in the sensing area SA. Specifically, the sensor 400 may be disposed in at least a part of an area corresponding to the sensing area SA of the display panel. For example, the sensor 400 may be disposed below the light transmittance portion AG and below the pixel area PIX adjacent to the light transmittance portion AG. The sensor 400 may include an optical sensor, but the present disclosure is not limited thereto, and may include various types of sensors such as an infrared sensor and/or an ultraviolet sensor.

A hole 410 is disposed in at least a portion of the boundary of the light transmittance portion AG (or the boundary of the opening). The hole 410 is disposed on the same plane as at least a portion of the second planarization layer PLN2 as shown in FIG. 4. The cathode CAT is disposed in at least a portion of the hole 410 formed at the boundary of the opening. The hole 410 is formed to have a predetermined depth. The depth of the hole 410 is predetermined and is less than a thickness of the second planarization layer PLN2.

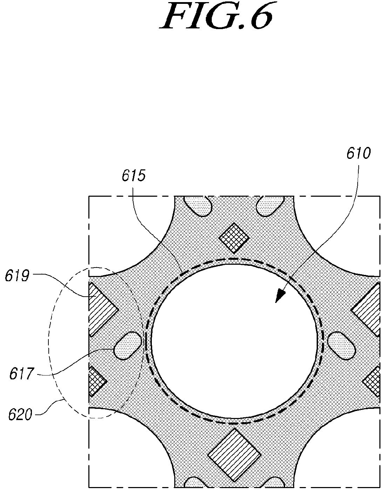

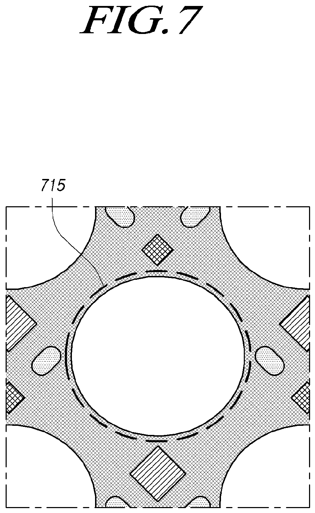

In the present invention, the hole 410 is formed to correspond to the boundary of the light transmittance portion AG. The hole 410 is formed to correspond to the boundary of the light transmittance portion AG along the boundary of the light transmittance portion AG. In this case, the hole 410 is formed in the same shape as the arrangement of the cathode CAT described later with reference to FIGS. 6 and 7.

FIG. 4 illustrates an example in which the cathode CAT is disposed up to a boundary line of the light transmittance portion AG along the surface of the hole 410, but the present disclosure is not limited thereto, and the cathode CAT is disposed on at least a part of the surface of the hole 410. Similar to the pixel area PIX, the inorganic insulating layer PAS2 may be disposed on the cathode CAT disposed in the hole 410.

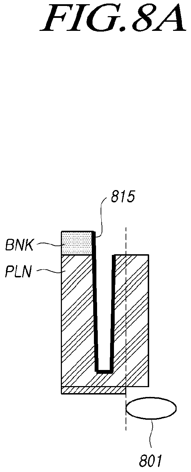

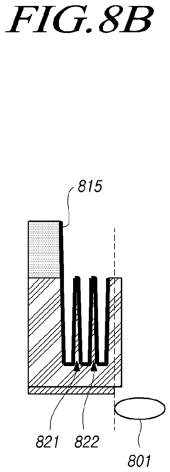

In an example embodiment, a plurality of holes may be configured. That is, a plurality of holes may be provided at the boundary of the light transmittance portion AG. The upper surface of a wall dividing the plurality of holes may be disposed on a different plane from an upper surface of the second planarization layer PLN2. However, the present disclosure is not limited thereto, and in some cases, the upper surface of the wall dividing the plurality of holes may be disposed on the same plane as the upper surface of the second planarization layer PLN2. More detailed description related thereto is provided later with reference to FIGS. 8A, 8B, and 8B.

If the plurality of holes are configured, a bottom surface of the hole may increase in proportion to the number of holes, but the present disclosure is not limited thereto. If the bottom surface of the hole increases in proportion to the number of holes, the area of the cathode CAT disposed on the hole at the boundary of the light transmittance portion AG may also increase. Some specific examples related thereto are described later with reference to FIGS. 6 and 7.

FIG. 5 is a diagram for explaining a hole of a display apparatus according to an example embodiment of the claimed invention. Specifically, FIG. 5 conceptually illustrates a cross-section of an example in which a hole and a cathode are disposed around the light transmittance portion. The sensor 530 may be positioned under the planarization layer 512 and the metal layer 517. The sensor 530 may be positioned to correspond to the opening of the metal layer 517.

Referring to FIG. 5, the light transmittance portion may include an opening 510 in which the cathode 515 is removed. Holes 520 are disposed at both ends of the opening 510. The hole 520 is formed to correspond to a boundary shape along the boundary of the opening 510. For example, if the opening 510 is formed in a circular shape and the boundary of the opening 510 has a circular shape, the hole 520 is formed along the boundary of the opening 510 in a circular shape surrounding the boundary of the opening 510. An example according to the claimed invention, in which the hole 520 is formed along the boundary of the opening 510 is described later with reference to FIGS. 6 and 7.

In an example embodiment, the hole 520 may be formed around the light transmittance portion AG with a predetermined gap. In this case, the hole 520 may be implemented as a plurality of holes, and a cathode 515 is deposited on at least a portion of each of the plurality of holes.

The hole 520 is formed in at least a portion of a planarization layer (or insulating layer), for example, a first planarization layer 511. The depth of the hole 520 is predetermined, while the width of the hole 520 may be predetermined. Specifically, the depth of the hole 520 may be formed to be greater than the width of the hole. For example, the depth of the hole 520 may be formed to be more than twice the width of the hole. In this case, the hole 520 may have a narrow and deep shape, such as when the first planarization layer 511 is pierced with a pin (needle). The hole 520 may be referred to as a pin hole according to an example embodiment.

In an example embodiment, after the hole 520 and a pixel defining layer 513 are formed, a cathode 515 is deposited. The cathode 515 may be formed on the pixel defining layer 513 and the cathode is disposed in at least a portion of the hole.

A second planarization layer 512 may be disposed under the first planarization layer 511. However, the present disclosure is not limited thereto, and the second planarization layer 512 may be omitted or may be formed integrally with the first planarization layer 511. The first planarization layer 511 may correspond to the second planarization layer PLN2 of FIG. 4, and the second planarization layer 512 may correspond to the first planarization layer PLN1 of FIG. 4.

In an example embodiment, a metal layer BSM 517 may be disposed under a plane on which the hole 520 is disposed, for example, under the second planarization layer 512. The metal layer 517 may extend to correspond to the end of the hole 520 or to be longer than the end of the hole 520. For example, one end of the metal layer 517 toward the opening 510 may be disposed to be closer to the opening 510 than one end of the hole 520 toward the opening 510. In this case, the lower region of the hole 520 may be covered by the metal layer 517.

In an example embodiment, although not illustrated for convenience of description, various configurations may be additionally disposed between the second planarization layer 512 and the metal layer 517. For example, an insulating layer or a TFT may be disposed between the second planarization layer 512 and the metal layer 517. Since an example related thereto has been described with reference to FIG. 4, a detailed description thereof is omitted for brevity. In addition, the configuration between the planarization layer and the metal layer may be omitted as described later in the present disclosure.

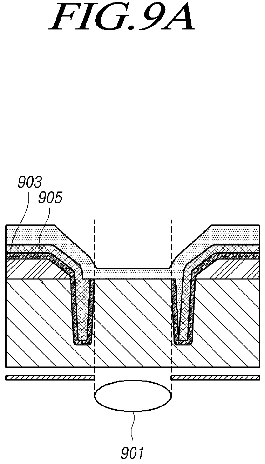

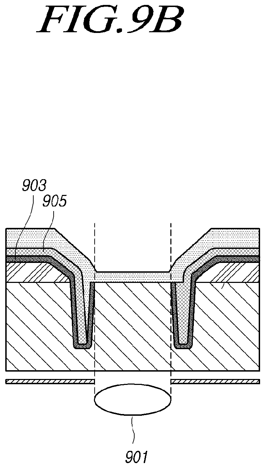

In an example embodiment, at least a portion of the emission layer EL may be disposed in the hole 520. In this case, the cathode 515 may be disposed on the emission layer. The area of the hole in which the emission layer EL is disposed and the area of the hole in which the cathode 515 is disposed may correspond to each other. An example thereof is provided later with reference to FIG. 9A. In some cases, the area of the hole in which the emission layer EL is disposed and the area of the hole in which the cathode 515 is disposed may be different. An example thereof is provided later with reference to FIG. 9B.

FIG. 5 briefly illustrates an example of a configuration in which the second planarization layer 512 is disposed under the first planarization layer 511; however, the present disclosure is not limited thereto.

In an example embodiment, the cathode 515 may be deposited on the hole by laser patterning. The cathode 515 formed based on laser patterning may be formed as thin as a thickness less than a predetermined value. After the cathode 515 is disposed in the hole, an inorganic insulating layer PAS1 may be disposed on the cathode 515. In this case, since the inorganic insulating layer PAS1 is disposed in the hole, the cathode 515 may be stably disposed without a lifting phenomenon in which one end is rolled up.

FIGS. 6 and 7 are diagrams for explaining examples and arrangements of holes of a display apparatus according to example embodiments of the claimed invention. Specifically, FIGS. 6 and 7 conceptually illustrate examples of a plane in which a hole is disposed along a boundary of a light transmittance portion (or an opening).

In an example embodiment, FIG. 6 illustrates a plane of at least a portion of the sensing area SA. A plurality of pixel groups (e.g., including a first pixel group 620) including at least one pixel (e.g., a first pixel 617 and a second pixel 619) are disposed around the light transmittance portion 610. In this case, the light transmittance portion 610 is disposed between at least two pixel groups.

In an example embodiment, each of the at least two pixel groups may include a pixel corresponding to at least one of red, green, blue, and white. For example, each of the at least two pixel groups may include a first pixel corresponding to a red color, a second pixel corresponding to a green color, and a third pixel corresponding to a blue color. As another example, each of the at least two pixel groups may include a first pixel corresponding to a red color, a second pixel corresponding to a green color, a third pixel corresponding to a blue color, and a fourth pixel corresponding to a white color.

The light transmittance portion 610 may transmit light. The light transmittance portion 610 may be formed in a circular shape. Accordingly, the boundary of the light transmittance portion 610 may correspond to a circular shape. The hole is formed along the boundary of the light transmittance portion 610, and a cathode 615 is disposed in at least a portion of the hole.

In an example embodiment, the surface of the light transmittance portion 610 may be implemented in various shapes. For example, the surface of the light transmittance portion 610 may have a circular shape or a polygonal shape. In this case, the hole is formed along the boundary of the light transmittance portion 610 to correspond to the shape of the surface of the light transmittance portion 610.

In an example embodiment, the cathode 615 may be formed while an area corresponding to at least a portion of the boundary of the light transmittance portion 610 is omitted. For example, the cathode 615 may be formed in a region corresponding to a portion (e.g., 1/2) of the periphery of the light transmittance portion 610.

In an example embodiment, according to the claimed invention, the first pixel group 620 is disposed on the planarization layer, and in this case, the hole is provided in the planarization layer. For example, the first pixel group 620 is disposed on the planarization layer, and a hole is provided in the planarization layer by removing at least a portion of the planarization layer.

In an example embodiment, although not illustrated, the cathode 615 may be included in at least one pixel, for example, the first pixel 617, included in at least two pixel groups disposed around the light transmittance portion. In this case, the cathode 615 may extend from the first pixel 617 to the upper end of the hole and be formed at the boundary of the light transmittance portion.

In an example embodiment, a planarization layer (or insulating layer) may be disposed on a driving circuit of at least two pixel groups disposed around the light transmittance portion. For example, the planarization layer may be disposed on the driving circuit of the first pixel group 620.

In an example embodiment, the thickness of a first point of the cathode 615 disposed on the hole may be less than the thickness of a second point of the cathode 615. In this case, the first point may be a point closer to the light transmittance portion than the second point. That is, the cathode 615 may be formed in a shape that becomes thinner as it approaches the light transmittance portion.

FIG. 7 illustrates an example in which a width of the hole is formed wider than that of FIG. 6. Hereinafter, in the description related to FIG. 7, a description of the content overlapping with that of FIG. 6 is omitted for brevity.

Referring to FIG. 7, the width of the hole is formed to be wider than that of FIG. 6, and thus the area of a cathode 715 disposed on the hole is formed to be larger.

In an example embodiment, a plurality of holes are formed along the boundary of the light transmittance portion. For example, the hole may be implemented to include a plurality of sub-holes. A sub-hole may refer to each of the divided spaces where a plurality of spaces are divided by columns included in the hole.

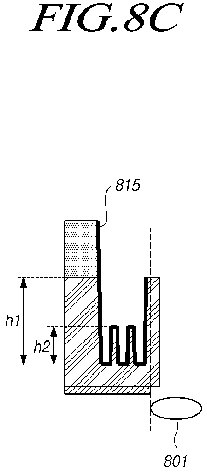

In this case, the width of each sub-hole may correspond to the width of the hole of FIG. 6. The cathode is disposed on the plurality of sub-holes, and thus the area of the cathode disposed on the holes is formed to be larger than that of FIG. 6. Some examples of the sub-hole are described later with reference to FIGS. 8A, 8B, and 8C.

In another embodiment, one hole may be formed so that the width of the bottom surface thereof is wider than that of FIG. 6. The width may be a predefined value.

FIGS. 8A, 8B, and 8C are diagrams for explaining examples of a hole of a display apparatus according to example embodiments of the claimed invention. Specifically, FIGS. 8A, 8B, and 8C conceptually illustrate example embodiments in which holes of a display apparatus are configured in various ways.

FIG. 8A illustrates an example in which the display apparatus includes one hole. FIG. 8A conceptually illustrates an example of a cross-section of the hole. As shown, the hole is formed in a shape deeply dug in at least a portion of the planarization layer PLN.

A cathode 815 is formed to cover at least a portion of the upper surface of the hole. FIG. 8A illustrates an example in which the cathode 815 completely covers the upper surface of the hole, but the present disclosure is not limited thereto. If the cathode 815 covers a portion of the upper surface of the hole, the thickness of the cathode 815 may decrease as it approaches the light transmittance portion AG.

FIGS. 8B and 8C illustrate examples in which a hole of the display apparatus includes a plurality of sub-holes.

As illustrated in FIG. 8B, there may be included a column dividing each of the plurality of sub-holes, for example, a first column 821 and a second column 822. The height of the first column 821 and the second column 822 may be the same as shown, but the present disclosure is not limited thereto and may be different from each other.

FIG. 8C illustrates another example embodiment in which a column dividing each of a plurality of sub-holes is implemented as a different shape from that illustrated in FIG. 8B. Specifically, the height of the column dividing each of the plurality of sub-holes may be predetermined as a first height. The first height may be lower than a depth of the hole. In this case, the depth h1 of the hole may correspond to a distance from an upper surface of the planarization layer PLN to a bottom surface of the hole, and the height h2 of the column may correspond to the distance from an upper surface of the column to the bottom surface of the hole.

In an example embodiment, a depth of the planarization layer PLN may be 2.3 µm, and the depth h1 of the hole may be 2.0 µm. The width of the upper part of the hole may be 1 µm, and the width of the lower part of the hole may be 0.5 µm. However, this is only an example, and the present embodiment is not limited to these examples.

FIGS. 9A and 9B are diagrams for explaining examples of a cathode disposed in a hole of a display apparatus according to example embodiments of the claimed invention. Specifically, FIGS. 9A and 8B conceptually illustrate examples of a cross-section of a region in which an emission layer and a cathode are disposed on a hole. For example, the emission layer associated with the at least one pixel is disposed in at least a portion of the hole. For example, the emission layer is disposed between an upper surface of the hole and a cathode disposed in at least a portion of the hole.

FIG. 9A illustrates that the emission layer 903 and the cathode 905 are disposed on at least a part of the upper surface of the hole. As shown in this example embodiment, on one side of the light transmittance portion AG, the emission layer 903 and the cathode 905 are disposed on the entire upper surface of the hole, and on the other side, the emission layer 903 and the cathode 905 are disposed on a part of the upper surface of the hole.

In an example embodiment, the thickness of the emission layer 903 and the cathode 905 may become thinner as it approaches the light transmittance portion AG, but the present disclosure is not limited thereto. The emission layer 903 may be associated with at least one pixel.

As shown, the cathode 905 and the emission layer 903 are disposed on the upper surface of the hole, and in this case, the cathode 905 may be disposed on the emission layer 903. However, the present disclosure is not limited thereto, and for example, only the cathode 905 is disposed without the emission layer 903.

As illustrated in FIG. 9B, the areas in which the emission layer 903 and the cathode 905 are disposed on the hole may be distinguished from each other. For example, the emission layer 903 may be disposed in a first area among the upper surfaces of the hole, and the cathode 905 is disposed in a second area, which is a wider area including the first area, among the upper surfaces of the hole. As another example, the emission layer 903 may be disposed on a first area of the upper surface of the hole, and the cathode 905 is disposed in a second area, which is narrower than the first area, among the upper surfaces of the hole.

In a display apparatus according to an example embodiment of the claimed invention, a hole is provided to correspond to the boundary of the light transmittance portion of the sensing area, and the cathode is disposed on the hole. Accordingly, the cathode is not provided in the light transmittance portion, so that it is possible to minimize the remaining residual film of the cathode and to minimize the occurrence of the lifting phenomenon in which one end of the cathode is rolled-up.

A display panel according to an example embodiment of the claimed invention includes a planarization layer on which pixels are disposed, a first area in which a plurality of pixels are disposed, and a second area comprising at least two pixel groups. Each of the at least two pixel groups includes at least one pixel, a light transmittance portion disposed between the at least two pixel groups to transmit light, and a hole formed to correspond to a boundary of the light transmittance portion along the boundary of the light transmittance portion. The hole is disposed on the same plane as at least a portion of the planarization layer and has a predetermined depth being less than a thickness of the planarization layer. A cathode related to the at least one pixel is disposed in at least a part of the hole.

In an example embodiment, a thickness of a first point of the cathode may be less than a thickness of a second point of the cathode, and the first point may be closer to the light transmittance portion than the second point.

In an example embodiment, an arrangement of the cathode may be omitted in the light transmittance portion. In an example embodiment, the cathode may have an opening formed in the light transmittance portion and may be disposed in an area other than the light transmittance portion.

In an example embodiment, the at least two pixel groups may be disposed on the planarization layer.

In an example embodiment, the hole may be provided in the planarization layer (e.g., by removing at least a part of the first layer), and the cathode may be disposed in a first pixel among the at least one pixel included in the at least two pixel groups and may extend from the first pixel to an upper end of the hole. In an example embodiment, the planarization layer is disposed on a driving circuit of the at least two pixel groups.

In an example embodiment, the hole may include a plurality of sub-holes. In an example embodiment, the plurality of sub-holes may be divided by at least one column having a first height. In an example embodiment, the first height may be less than a depth of the hole. In an example embodiment, an emission layer associated with the at least one pixel may be disposed in at least a portion of the hole. In an example embodiment, the emission layer may be disposed between an upper surface of the hole and the cathode disposed in at least a portion of the hole.

In an example embodiment, a surface of the light transmittance portion may have a circle shape or a polygon shape.

In an example embodiment, each of the at least two pixel groups may include a pixel corresponding to at least one of a red color, a green color, a blue color, and a white color. In an example embodiment, a pixel density of the second area may be lower than a pixel density of the first area.

A display apparatus according to an example embodiment of the claimed invention includes a display panel comprising a planarization layer on which pixels are disposed, a first area in which a plurality of pixels are disposed, and a second area including at least two pixel groups. Each of the at least two pixel groups includes at least one pixel, a light transmittance portion disposed between the at least two pixel groups to transmit light, and a hole formed to correspond to a boundary of the light transmittance portion along the boundary of the light transmittance portion. The hole is disposed on the same plane as at least a portion of the planarization layer and has a predetermined depth being less than a thickness of the planarization layer. A cathode related to the at least one pixel is disposed in at least a part of the hole.

In an example embodiment, a thickness of a first point of the cathode may be less than a thickness of a second point of the cathode, and the first point may be closer to the light transmittance portion than the second point.

In an example embodiment, an arrangement of the cathode may be omitted in the light transmittance portion.

In an example embodiment, the at least two pixel groups may be disposed on the planarization layer, and the hole is disposed in the planarization layer (e.g., by removing at least a portion of the planarization layer). In an example embodiment, the cathode may be disposed in a first pixel among the at least one pixel included in the at least two pixel groups and may extend from the first pixel to an upper end of the hole. In an example embodiment, the planarization laye is disposed on a driving circuit of the at least two pixel groups.

In an example embodiment, the display apparatus may further include an optical sensor disposed on one side of the display panel to correspond to the second area.

In an example embodiment, the optical sensor may include at least one of a camera and an infrared sensor.

Although the embodiments of the present disclosure have been described in detail with reference to the accompanying drawings, the present invention is not necessarily limited to these embodiments, and various modifications may be within the scope of the present invention. Accordingly, the embodiments disclosed in the present disclosure are not intended to limit the scope of the present invention, but to exemplarily explain the present invention, and the scope of the present invention is not limited by these embodiments. Therefore, there should be understood that the embodiments described above are illustrative in all respects and not restrictive. The protection scope of the present invention should be construed by the following claims.

## Claims

1. A display panel, comprising:
a planarization layer (PLN) on which pixels are disposed,
a first area (GA) in which a plurality of pixels (PIX) are disposed; and
a second area (SA) comprising at least two pixel groups (PG),
wherein each of the at least two pixel groups (PG) comprises:
at least one pixel (PIX);
a light transmittance portion (AG) disposed between the at least two pixel groups (PG) to transmit light; and
a hole (410) formed to correspond to a boundary of the light transmittance portion (AG) along the boundary of the light transmittance portion (AG),
wherein the hole (410) is disposed on the same plane as at least a portion of the planarization layer (PLN) and has a predetermined depth being less than a thickness of the planarization layer (PLN), and
wherein a cathode (CAT, 905) related to the at least one pixel (PIX) is disposed in at least a part of the hole (410).

2. The display panel of claim 1, wherein a thickness of a first point of the cathode (CAT, 905) is less than a thickness of a second point of the cathode (CAT, 905), and
wherein the first point is closer to the light transmittance portion (AG) than the second point.

3. The display panel of claim 1 or 2, wherein an arrangement of the cathode (CAT, 905) is omitted in the light transmittance portion (AG).

4. The display panel of any of claims 1 to 3,
wherein the cathode (CAT, 905) is disposed in a first pixel among the at least one pixel (PIX1) included in the at least two pixel groups (PG), and the cathode (CAT, 905) extends from the first pixel to an upper end of the hole (410).

5. The display panel of claim 4, wherein the planarization layer (PLN1, PLN2) is disposed on a driving circuit of the at least two pixel groups (PG).

6. The display panel of any of claims 1 to 5, wherein the hole (410) comprises a plurality of sub-holes.

7. The display panel of claim 6, wherein the plurality of sub-holes are divided by at least one column (821, 822) having a first height (h2).

8. The display panel of claim 7, wherein the first height is less than a depth (h1) of the hole (410).

9. The display panel of any of claims 1 to 8, wherein an emission layer (903) associated with the at least one pixel (PIX) is disposed in at least a portion of the hole (410).

10. The display panel of claim 9, wherein the emission layer (903) is disposed between an upper surface of the hole and the cathode (CAT, 905) disposed in at least a part of the hole (410).

11. The display panel of any of claims 1 to 10, wherein a surface of the light transmittance portion (AG) has a circle shape or a polygon shape.

12. The display panel of any of claims 1 to 11, wherein each of the at least two pixel groups (PG) comprises a pixel (PIX) corresponding to at least one of a red color, a green color, a blue color, and a white color.

13. The display panel of claim 12, wherein a pixel density of the second area (SA) is lower than a pixel density of the first area (GA).

14. A display apparatus (100), comprising the display panel of any of claims 1 to 13.

15. The display apparatus of claim 14, wherein the display apparatus (100) further includes an optical sensor disposed on one side of the display panel to correspond to the second area (SA), wherein, preferably, the optical sensor comprises at least one of a camera and an infrared sensor.

## Patentansprüche

1. Anzeigepanel, aufweisend:
eine Planarisierungsschicht (PLN), auf der Pixel angeordnet sind,
einen ersten Bereich (GA), in dem eine Mehrzahl von Pixeln (PIX) angeordnet sind, und
einen zweiten Bereich (SA), der mindestens zwei Pixelgruppen (PG) aufweist,
wobei jede der mindestens zwei Pixelgruppen (PG) aufweist:
mindestens ein Pixel (PIX),
einen Lichtdurchlässigkeitsabschnitt (AG), der zwischen den mindestens zwei Pixelgruppen (PG) angeordnet ist, um Licht durchzulassen, und
ein Loch (410), das ausgebildet ist, um zu einer Grenze des Lichtdurchlässigkeitsabschnitt (AG) zu korrespondieren, entlang der Grenze des Lichtdurchlässigkeitsabschnitt (AG),
wobei das Loch (410) auf der gleichen Ebene wie mindestens ein Abschnitt der Planarisierungsschicht (PLN) angeordnet ist und eine vorbestimmte Tiefe hat, die kleiner als eine Dicke der Planarisierungsschicht (PLN) ist, und
wobei eine Kathode (CAT, 905), die mit dem mindestens einen Pixel (PIX) in Beziehung steht, in mindestens einem Teil des Lochs (410) angeordnet ist.

2. Anzeigepanel gemäß Anspruch 1, wobei eine Dicke eines ersten Punktes der Kathode (CAT, 905) kleiner als eine Dicke eines zweiten Punktes der Kathode (CAT, 905) ist, und
wobei der erste Punkt näher bei dem Lichtdurchlässigkeitsabschnitt (AG) liegt als der zweite Punkt.

3. Anzeigepanel gemäß Anspruch 1 oder 2, wobei eine Anordnung der Kathode (CAT, 905) in dem Lichtdurchlässigkeitsabschnitt (AG) weggelassen ist.

4. Anzeigepanel gemäß irgendeinem der Ansprüche 1 bis 3,
wobei die Kathode (CAT, 905) in einem ersten Pixel von dem mindestens einen Pixel (PIX1), das in den mindestens zwei Pixelgruppen (PG) enthalten ist, angeordnet ist und die Kathode (CAT, 905) sich von dem ersten Pixel zu einem oberen Ende des Lochs (410) erstreckt.

5. Anzeigepanel gemäß Anspruch 4, wobei die Planarisierungsschicht (PLN1, PLN2) auf einer Treiberschaltung der mindestens zwei Pixelgruppen (PG) angeordnet ist.

6. Anzeigepanel gemäß irgendeinem der Ansprüche 1 bis 5, wobei das Loch (410) eine Mehrzahl von Sublöchern aufweist.

7. Anzeigepanel gemäß Anspruch 6, wobei die Mehrzahl von Sublöchern durch mindestens eine Säule (821, 822) mit einer ersten Höhe (h2) unterteilt sind.

8. Anzeigepanel gemäß Anspruch 7, wobei die erste Höhe kleiner als eine Tiefe (h1) des Lochs (410) ist.

9. Anzeigepanel gemäß irgendeinem der Ansprüche 1 bis 8, wobei eine mit dem mindestens einen Pixel (PIX) assoziierte Emissionsschicht (903) in mindestens einem Abschnitt des Lochs (410) angeordnet ist.

10. Anzeigepanel gemäß Anspruch 9, wobei die Emissionsschicht (903) zwischen einer oberen Fläche des Lochs und der Kathode (CAT, 905) angeordnet ist, die in mindestens einem Teil des Lochs (410) angeordnet ist.

11. Anzeigepanel gemäß irgendeinem der Ansprüche 1 bis 10, wobei eine Fläche des Lichtdurchlässigkeitsabschnitts (AG) eine Kreisform oder eine Polygonform hat.

12. Anzeigepanel gemäß irgendeinem der Ansprüche 1 bis 11, wobei jede der mindestens zwei Pixelgruppen (PG) ein Pixel (PIX) aufweist, das zu mindestens einer von einer roten Farbe, einer grünen Farbe, einer blauen Farbe und einer weißen Farbe korrespondiert.

13. Anzeigepanel gemäß Anspruch 12, wobei eine Pixeldichte des zweiten Bereichs (SA) kleiner als eine Pixeldichte des ersten Bereichs (GA) ist.

14. Anzeigevorrichtung (100), aufweisend das Anzeigepanel gemäß irgendeinem der Ansprüche 1 bis 13.

15. Anzeigevorrichtung gemäß Anspruch 14, wobei die Anzeigevorrichtung (100) ferner einen optischen Sensor aufweist, der auf einer Seite des Anzeigepanels angeordnet ist, um zu dem zweiten Bereich (SA) zu korrespondieren, wobei der optische Sensor vorzugsweise mindestens eines von einer Kamera und einem Infrarotsensor aufweist.

## Revendications

1. Panneau d'affichage, comprenant :
une couche de planarisation (PLN) sur laquelle des pixels sont disposés,
une première zone (GA) dans laquelle une pluralité de pixels (PIX) sont disposés, et
une deuxième zone (SA) comprenant au moins deux groupes de pixels (PG),
dans lequel chacun des au moins deux groupes de pixels (PG) comprend :
au moins un pixel (PIX),
une partie de transmission de lumière (AG) disposée entre les au moins deux groupes de pixels (PG) pour transmettre de la lumière, et
un trou (410) formé pour correspondre à une limite de la partie de transmission de lumière (AG) le long de la limite de la partie de transmission de lumière (AG),
dans lequel le trou (410) est disposé sur le même plan qu'au moins une partie de la couche de planarisation (PLN) et a une profondeur prédéterminée inférieure à une épaisseur de la couche de planarisation (PLN), et
dans lequel une cathode (CAT, 905) associée audit au moins un pixel (PIX) est disposée dans au moins une partie du trou (410).

2. Panneau d'affichage selon la revendication 1, dans lequel une épaisseur d'un premier point de la cathode (CAT, 905) est inférieure à une épaisseur d'un deuxième point de la cathode (CAT, 905), et
dans lequel le premier point est plus proche de la partie de transmission de lumière (AG) que le deuxième point.

3. Panneau d'affichage selon la revendication 1 ou 2, dans lequel un agencement de la cathode (CAT, 905) est omis dans la partie de transmission de lumière (AG).

4. Panneau d'affichage selon l'une quelconque des revendications 1 à 3,
dans lequel la cathode (CAT, 905) est disposée dans un premier pixel parmi ledit au moins un pixel (PIX1) inclus dans les au moins deux groupes de pixels (PG), et la cathode (CAT, 905) s'étend du premier pixel à une extrémité supérieure du trou (410).

5. Panneau d'affichage selon la revendication 4, dans lequel la couche de planarisation (PLN1, PLN2) est disposée sur un circuit de commande des au moins deux groupes de pixels (PG).

6. Panneau d'affichage selon l'une quelconque des revendications 1 à 5, dans lequel le trou (410) comprend une pluralité de sous-trous.

7. Panneau d'affichage selon la revendication 6, dans lequel la pluralité de sous-trous est divisée par au moins une colonne (821, 822) ayant une première hauteur (h2).

8. Panneau d'affichage selon la revendication 7, dans lequel la première hauteur est inférieure à une profondeur (h1) du trou (410).

9. Panneau d'affichage selon l'une quelconque des revendications 1 à 8, dans lequel une couche d'émission (903) associée audit au moins un pixel (PIX) est disposée dans au moins une partie du trou (410).

10. Panneau d'affichage selon la revendication 9, dans lequel la couche d'émission (903) est disposée entre une surface supérieure du trou et la cathode (CAT, 905) disposée dans au moins une partie du trou (410).

11. Panneau d'affichage selon l'une quelconque des revendications 1 à 10, dans lequel une surface de la partie de transmission de lumière (AG) a une forme circulaire ou une forme polygonale.

12. Panneau d'affichage selon l'une quelconque des revendications 1 à 11, dans lequel chacun des au moins deux groupes de pixels (PG) comprend un pixel (PIX) correspondant à au moins l'une parmi une couleur rouge, une couleur verte, une couleur bleue et une couleur blanche.

13. Panneau d'affichage selon la revendication 12, dans lequel une densité de pixels de la deuxième zone (SA) est inférieure à une densité de pixels de la première zone (GA).

14. Dispositif d'affichage (100), comprenant le panneau d'affichage selon l'une quelconque des revendications 1 à 13.

15. Dispositif d'affichage selon la revendication 14, dans lequel le dispositif d'affichage (100) comprend en outre un capteur optique disposé sur un côté du panneau d'affichage pour correspondre à la deuxième zone (SA), dans lequel, de préférence, le capteur optique comprend au moins l'un d'une caméra et d'un capteur infrarouge.
